Europäisches Patentamt

European Patent Office

Office européen des brevets

(11) Numéro de publication: **0 053 967**

**A1**

## (12) DEMANDE DE BREVET EUROPEEN

(21) Numéro de dépôt: **81401869.3**

(22) Date de dépôt: **25.11.81**

(51) Int. Cl.³: **H 01 L 23/40**
**H 01 L 23/36**

(30) Priorité: **05.12.80 FR 8025857**

(43) Date de publication de la demande:
**16.06.82 Bulletin 82/24**

(84) Etats contractants désignés:
**CH DE FR GB IT LI NL**

(71) Demandeur: **COMPAGNIE INTERNATIONALE POUR L'INFORMATIQUE CII - HONEYWELL BULL (dite CII-HB)**
**94, avenue Gambetta**
**F-75020 Paris(FR)**

(72) Inventeur: **Dehaine, Gérard**
**94 avenue Gambetta**
**F-75020 Paris(FR)**

(74) Mandataire: **Denis, Hervé**
**94, avenue Gambetta**
**F-75020 Paris(FR)**

(54) **Dispositif de refroidissement amovible pour supports de circuits intégrés.**

(57) L'invention concerne un support (10) de dispositifs à circuits intégrés (11), destiné à recevoir un dispositif de refroidissement (12), tel qu'un radiateur, sur une face (136) du substrat (13) du support.

Selon l'invention, une feuille (16) est intercalée entre le radiateur (12) et le substrat (13), ayant un coefficient de dilatation thermique voisin de celui du matériau constituant le substrat (13), de sorte qu'il est possible d'attacher amoviblement le radiateur sur la feuille (16).

L'invention s'applique également aux dispositifs de refroidissement par circulation de liquide.

FIG.1

DISPOSITIF DE REFROIDISSEMENT AMOVIBLE POUR SUPPORTS DE CIRCUITS INTEGRES

L'invention a pour objet un dispositif de refroidissement amovible pour supports de circuits intégrés.

Les dispositifs à circuits intégrés sont des éléments minces, dont l'une des grandes faces, dite face active, inclut les circuits électroniques et les bornes d'entrée-sortie sur lesquelles sont fixées les pattes de raccordement (leads).

Un support de dispositifs à circuits intégrés est formé à partir d'une plaque -désignée généralement sous le nom de "substrat"- faite en un matériau isolant, l'alumine habituellement. Une face du substrat présente des zones, délimitées chacune par des plots destinés à fixer et relier électriquement les pattes d'un dispositif à circuits intégrés, et comporte un réseau métallique d'interconnexion destiné à relier les dispositifs à circuits intégrés entre eux ainsi qu'à des bornes d'entrée-sortie du substrat. La fixation d'un dispositif à circuits intégrés sur une zone du substrat est actuellement faite par thermocollage de la grande face non active de ce dispositif et par soudage des pattes préalablement cambrées du dispositif sur les plots entourant chaque zone. Sur l'autre grande face du substrat, appelée face de dissipation thermique, est fixé un dispositif de refroidissement, généralement un radiateur à ailettes. Jusqu'à présent, les substrats avaient une surface d'environ 50mm x 50mm, et les dispositifs à circuits intégrés, une surface maximale de l'ordre de 3mm x 3mm. Le radiateur était collé aux substrats.

L'intégration à grande échelle des circuits de ces dispositifs (Large Scale Integration - LSI ; Very Large

Scale Integration - VLSI) conduit à l'avènement de dispositifs à circuits intégrés de grandes surfaces (par exemple 5mm x 5mm et plus) et pourvus d'un grand nombre de pattes (150 à 200 par exemple). Parallèlement, il y a concentration des plots et du réseau métallique d'interconnexion, grâce à une technique élaborée de la sérigraphie (20 à 30 couches par exemple), et augmentation de la surface du substrat qui est de l'ordre de 80 mm x 80mm à l'heure actuelle.

Cette évolution des substrats d'interconnexion de dispositifs soulève plusieurs problèmes.

D'abord, le dépôt par sérigraphie du réseau d'interconnexion nécessite autant de cuissons du substrat qu'il y a de couches conductrices et isolantes pour la solidification de ces couches. Les cuissons et refroidissements successifs ont pour effet de voiler le substrat, d'autant plus que celui-ci a une surface élevée. Le radiateur à ailettes étant un élément métallique rigide présentant une face plane, la couche de colle qui fixe ce radiateur à la face plus ou moins voilée du substrat est plus ou moins épaisse. Il s'ensuit que la résistance thermique du trajet de dissipation de la chaleur délivrée par les dispositifs n'est pas uniforme sur toute la face de dissipation et que la résistance d'adhérence du radiateur au substrat peut être localement insuffisante et rendre fragile la fixation du radiateur.

Un autre problème réside dans le démontage d'un dispositif défaillant en vue de son remplacement. Etant donné que les dispositifs sont soudés aux plots des substrats, il faut chauffer les soudures jusqu'à atteindre leur température de fusion. Cependant, à cause de l'évacuation des calories vers le radiateur et de la relativement faible résistance thermique des dispositifs due à leur plus grande surface, le dessoudage d'un dispositif est difficile et provoque généralement des effets néfastes sur le substrat, rendant le soudage du nouveau dispositif malaisé et moins fiable, voire impossible.

Par ailleurs, pour monter et démonter un support de dispositifs à circuits intégrés sur une carte de circuits imprimés, le radiateur peut être gênant selon le dispositif utilisé pour la connexion électrique du support à la carte. Par exemple, si ce dispositif comprend des pattes à souder sur des plages conductrices de la carte, le radiateur doit être limité à une surface prédéterminée laissant le passage à la panne de soudage des pattes.

Pour remédier à ces inconvénients, la solution de l'invention consiste à rendre amovible le radiateur. En effet, en enlevant le radiateur du substrat, le dessoudage d'un dispositif défaillant et de ressoudage du dispositif de remplacement se font simplement, et de manière fiable, tandis que la fixation du substrat à une carte devient alors indépendante de l'encombrement du dispositif de refroidissement.

Mais l'amovibilité du radiateur au substrat se heurte à de nombreuses difficultés. La principale difficulté vient du fait que le matériau isolant du substrat (ordinairement l'alumine) a un coefficient de dilatation thermique nettement différent des matériaux susceptibles de remplir convenablement le rôle de radiateur. A titre d'exemple, le coefficient de l'alumine est de 6,4 x $10^{-6}$/°C, tandis que celui du cuivre est de 17,8 x $10^{-6}$/°C et celui de l'aluminium de 25,7 x $10^{-6}$/°C. Par conséquent, la fixation par collage de tiges filetées directement sur le substrat pour recevoir et fixer le radiateur s'avère précaire à cause des variations différentielles du substrat et du radiateur.

Un support de circuits intégrés conforme à l'invention est du type destiné à recevoir sur sa face de dissipation un dispositif de refroidissement, et est caractérisé en ce qu'il comporte une feuille fixée à ladite face de dissipation du support, ayant un coefficient de dilatation voisin de celui du matériau constituant ledit support et présentant des moyens pour fixer sur cette feuille ledit dispositif de refroidissement.

Pour l'alumine comme matériau constituant le support, le matériau de la feuille sera avantageusement celui désigné par la marque "Kovar", dont la composition est de 53,7 % de fer, 28,8 % de nickel, 17,2 % de cobalt, et 0,3 % de manganèse, et dont le coefficient de dilatation thermique est d'environ $5,8 \times 10^{-6}$/°C. La fixation de cette feuille peut être faite par collage au moyen d'une colle époxy à température de polymérisation relativement basse, par exemple aux alentours de 150°C, ou par soudage, par exemple avec un alliage d'étain-plomb solidifiant à 183°C.

Les caractéristiques et avantages de l'invention ressortiront plus clairement dans la description qui suit, faite en référence à la planche unique de dessins annexés.

Dans les dessins :

- la figure 1 est une vue partielle en coupe d'un exemple de réalisation d'un support de dispositifs à circuits intégrés conforme à l'invention, pourvu d'un radiateur amovible ; et

- la figure 2 est une vue partielle en coupe d'une variante de réalisation conforme à l'invention d'un support de dispositifs à circuits intégrés, pourvu d'un dispositif amovible à liquide de refroidissement.

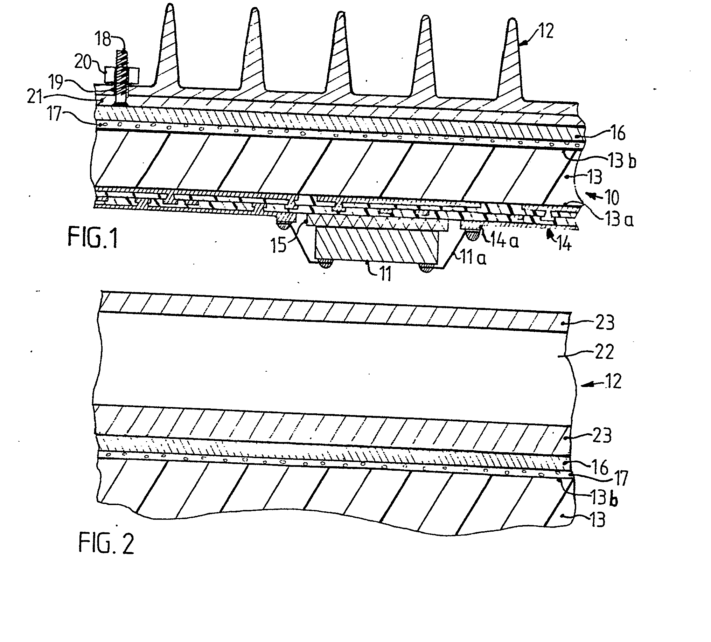

En référence à la figure 1, le support (10) de dispositifs à circuits intégrés tels que le dispositif (11), comporte conformément à l'invention un dispositif de refroidissement amovible (12) représenté à titre d'exemple sous la forme d'un radiateur métallique à ailettes sur la figure 1. Le support (10) illustré est formé à partir d'un substrat (13), en alumine par exemple, ayant, d'une part, une face de support (13a) d'un réseau métallique d'interconnexion multicouche (14) (trois couches métalliques étant représentées) sur lequel les dispositifs tels que (11) sont fixés par leurs pattes (11a) aux plots correspondants (14a) du réseau (14) et par leur face non active au moyen d'une couche de colle (15) et, d'autre part, une face de dissipation (13b) destinée à coopérer avec le dispositif de refroidissement (12).

Suivant la technique antérieure, le radiateur (12) était directement collé à la face de dissipation (13b) du substrat (13).

Selon l'exemple de réalisation conforme à l'invention illustré à la figure 1, le radiateur (12), en aluminium par exemple, est monté amoviblement sur le support (10), grâce à un moyen de fixation amovible comprenant essentiellement une feuille (16) fixée à la face de dissipation (13b) du support (10) et ayant un coefficient de dilatation voisin de celui du matériau constituant le substrat (13). Ce dernier étant l'alumine, la feuille (16) sera avantageusement en Kovar par exemple. La feuille (16) est fixée au substrat (13) par une couche de fixation (17). Cette couche peut être formée d'une colle époxy à faible température de polymérisation, de l'ordre de 150°C par exemple, ou de la soudure telle que par exemple un alliage étain-plomb qui a l'avantage de solidifier à la température relativement basse de 183°C. Comme ordre de grandeur, la feuille (16) a 250µm d'épaisseur, et la couche (17), de 100 à 200µm. De la sorte, la feuille (16) est flexible et peut ainsi épouser la forme de la face de dissipation (13b) du substrat.

Selon l'exemple de la figure 1, des tiges filetées, telles que la tige (18), sont fixées par soudage ou collage à la feuille (16) normalement au plan de celle-ci, tandis que le radiateur (12) comporte des ouvertures (19) correspondantes pour coopérer avec les tiges (18) et être fixées à ces tiges au moyen d'écrous (20).

Eventuellement, comme représenté sur la figure 1, une mousse bonne conductrice de la chaleur (21) peut être interposée entre le radiateur (12) et la feuille (16), en vue d'assurer une bonne liaison thermique entre la feuille (16) et le radiateur (12) malgré les défauts de planéité susceptibles d'exister entre ces deux éléments métalliques. A titre d'illustration, la mousse (21) peut être une mousse de silicone chargée en alumine ou en argent, d'une épaisseur de l'ordre de 300 à 500µm.

En enlevant le radiateur (12), le dessoudage des pattes (11a) sur les plots (14a) du réseau d'interconnexion (14) et le décollage du dispositif de la couche (15) se pratiquent aisément quand on veut remplacer un dispositif défaillant (11), et la mise en place du nouveau dispositif est aussi aisée et fiable. D'autre part, dans certaines conditions, il peut être avantageux de remplacer un type de radiateur par un autre plus performant ou moins encombrant, ce que permet le montage de l'invention.

L'invention peut comporter plusieurs variantes. Selon la variante illustrée à la figure 2, on utilise les propriétés magnétiques du Kovar pour fixer directement le dispositif de refroidissement (12) par attraction magnétique contre la feuille (16), par exemple en aimantant convenablement la face du dispositif de refroidissement qui est en contact avec la feuille (16). En variante également, le dispositif de refroidissement (12) représenté sur la figure 2 n'est pas un radiateur, mais un élément à canaux (22) de refroidissement par circulation d'un fluide de refroidissement dans ces canaux, délimités par des parois (23). Le fluide de refroidissement peut être de l'eau. La paroi (23) destinée à entrer en contact avec la feuille (16) est magnétisable ou magnétisée convenablement pour assurer la fixation désirée du dispositif de refroidissement (12) à la feuille (16).

REVENDICATIONS

1. Support de dispositifs à circuits intégrés, du type destiné à recevoir sur sa face de dissipation un dispositif de refroidissement, caractérisé en ce qu'il comporte une feuille fixée à la face de dissipation du support, ayant un coefficient de dilatation thermique voisin de celui du matériau constituant le support et présentant des moyens pour fixer sur cette feuille ledit dispositif de refroidissement.

2. Support selon la revendication 1, caractérisé en ce que les moyens de fixation du dispositif de refroidissement comprennent des tiges filetées, fixées normalement au plan de la feuille précitée.

3. Support selon la revendication 1, caractérisé en ce que, les moyens de fixation du dispositif de refroidissement sont des moyens attirant magnétiquement le dispositif de refroidissement à ladite feuille.

4. Support selon l'une quelconque des revendications 1 à 3, caractérisé en ce que la feuille est fixée par adhérence au support.

5. Support selon l'une quelconque des revendications 1 à 4, caractérisé en ce que la feuille est suffisamment flexible pour épouser sensiblement les variations de surface de ladite face de dissipation.

6. Support selon l'une quelconque des revendications 1 à 5, caractérisé en ce que la feuille comporte extérieurement une mousse conductrice de la chaleur.

7. Support selon l'une quelconque des revendications précédentes, caractérisé en ce que le dispositif de refroidissement est un radiateur à ailettes.

FIG.1

FIG. 2

0053967

**RAPPORT DE RECHERCHE EUROPEENNE**

Office européen
des brevets

Numéro de la demande

EP 81 40 1869

## DOCUMENTS CONSIDERES COMME PERTINENTS

| Catégorie | Citation du document avec indication, en cas de besoin, des parties pertinentes | Revendication concernée |
|-----------|--------------------------------------------------------------------------------|-------------------------|
| Y | IBM TECHNICAL DISCLOSURE BULLETIN, vol. 21, no. 3, août 1978 New York, US R.D. DURAND et al.: "Ceramic Cap and Heat Sink for Semiconductor Package", pages 1064-1065 <br><br> * Figure 2; page 1065, alinéa 2 * <br> -- | 1,2,5, 7 |
| Y | US - A - 4 025 997 (INTERN. TELEPHONE & TELEGRAPH) <br><br> * Figure 1b; table 1, colonne 4, lignes 33-56 * <br> -- | 1 |
| A | EP - A - 0 000 856 (IBM) <br><br> * Figure 2, revendications 1,2 * <br> -- | 3,7 |
| A | GB - A - 881 571 (STONE) <br><br> * Figure 3; page 1, lignes 40-63 * <br> -- | 2,5-7 |
| A | FR - A - 2 236 272 (SIEMENS) <br><br> * Figure 1, revendications 1,4 * <br> ---- | 2,4,5 |

**CLASSEMENT DE LA DEMANDE (Int. Cl. 3)**

H 01 L 23/40
23/36

**DOMAINES TECHNIQUES RECHERCHES (Int. Cl. 3)**

H 01 L

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons

&: membre de la même famille, document correspondant

⊠ Le présent rapport de recherche a été établi pour toutes les revendications

| Lieu de la recherche | Date d'achèvement de la recherche | Examinateur |
|----------------------|-----------------------------------|-------------|
| La Haye | 22-03-1982 | DE RAEVE |

OEB Form 1503.1 06.78